(19) Europäisches Patentamt

European Patent Office

Office européen des brevets

(11) EP 4 628 848 A1

## (12) EUROPEAN PATENT APPLICATION

(43) Date of publication:
08.10.2025 Bulletin 2025/41

(21) Application number: 25162462.3

(22) Date of filing: 07.03.2025

(51) International Patent Classification (IPC):
G01D 3/036 $^{(2006.01)}$     G01R 33/00 $^{(2006.01)}$

(52) Cooperative Patent Classification (CPC):
G01D 3/036; G01R 33/0029

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 28.03.2024 US 202418619265

(71) Applicant: Allegro MicroSystems, LLC
Manchester, NH 03103-3353 (US)

(72) Inventors:
• PAVLOV, Emil
  Heidelberg (DE)
• DOGANOV, Rostislav
  Schwetzingen (DE)

(74) Representative: South, Nicholas Geoffrey et al
Venner Shipley LLP
200 Aldersgate
London EC1A 4HD (GB)

## (54) MULTIPLE-SENSITIVITY SENSOR WITH DYNAMIC OFFSET CORRECTION AND HIGH DYNAMIC RANGE

(57) A method is provided for use in a sensor, comprising: generating a sensing signal by using one or more sensing elements; amplifying the sensing signal by using a first gain to produce, at least in part, a first amplified signal, the first amplified signal having a first offset; amplifying the sensing signal by using a second gain to produce, at least in part, a second amplified signal, the second amplified signal having a second offset; generating an adjusted signal based on the first amplified signal, the second amplified signal, the first gain, and the second gain, the adjusted signal approximating a difference between the second amplified signal and an offset of the second amplified signal; and using the adjusted signal to generate an output of the sensor.

EP 4 628 848 A1

## Description

BACKGROUND

As is known, sensors are used to perform various functions in a variety of applications. Some sensors include one or more electromagnetic flux sensing elements, such as a Hall effect element, a magnetoresistive element, or a receiving coil to sense an electromagnetic flux associated with proximity or motion of a target object. Sensor integrated circuits are widely used in automobile control systems and other safety-critical applications. There are a variety of specifications that set forth requirements related to permissible sensor quality levels, failure rates, and overall functional safety.

SUMMARY

According to aspects of the disclosure, a method is provided for use in a sensor, comprising: generating a sensing signal by using one or more sensing elements; amplifying the sensing signal by using a first gain to produce, at least in part, a first amplified signal, the first amplified signal having a first offset; amplifying the sensing signal by using a second gain to produce, at least in part, a second amplified signal, the second amplified signal having a second offset; generating an adjusted signal based on the first amplified signal, the second amplified signal, the first gain, and the second gain, the adjusted signal approximating a difference between the second amplified signal and an offset of the second amplified signal; and using the adjusted signal to generate an output of the sensor.

In an embodiment, the method further provides retrieving, from a memory, an offset proportionality constant that is indicative of a ratio between the first offset and the second offset, wherein the adjusted signal is calculated further based on the offset proportionality constant.

In an embodiment, generating the adjusted signal includes calculating the second offset based on the first amplified signal, the second amplified signal, the first gain, and the second gain, and subtracting the second offset from the second amplified signal.

In an embodiment, calculating the adjusted signal includes calculating a ratio between (i) a difference between the first and second amplified signals and (ii) a difference between the first gain and the second gain.

In an embodiment, calculating the adjusted signal includes scaling the second amplified signal based on an offset proportionality constant to produce a scaled second amplified signal, scaling the second gain based on the offset proportionality constant to produce a scaled second gain, and calculating a ratio between (i) a difference between the first amplified signal and the scaled second amplified signal, and (ii) a difference between the second gain and the scaled second gain.

In an embodiment, generating the adjusted signal includes calculating the second offset based on the first amplified signal, the second amplified signal, the first gain, and the second gain, and subtracting the second offset from the second amplified signal, the second offset being calculated in accordance with the equation of:

$$V_{Q2} = \frac{s_2 V_1 - s_1 V_2}{s_2 A - s_1}$$

where $V_{Q2}$ is the second offset, $s_1$ is the first gain, $s_2$ is the second gain, $V_1$ is the first amplified signal, $V_2$ is the second amplified signal, $A$ is an offset proportionality constant that is indicative of a ration between the first amplified signal and the second amplified signal, and $A \geq 1$.

In an embodiment, the adjusted signal is calculated in accordance with the equation of:

$$V_{ADJ} = \frac{V_1 - AV_2}{s_1 - As_2}$$

where $V_{ADJ}$ is the adjusted signal, $s_1$ is the first gain, $s_2$ is the second gain, $V_1$ is the first amplified signal, $V_2$ is the second amplified signal, $A$ is an offset proportionality constant that is indicative of a ration between the first amplified signal and the second amplified signal, and $A \geq 1$.

In an embodiment, each of the sensing elements includes a magnetic field sensing element.

In an embodiment, each of the sensing elements includes one of a strain gauge element, a thermistor, a photoresistor, a humidity sensing element, a gas sensing element, or a force sensing element.

In an embodiment, the first amplified signal is generated by using a first amplifier and the second amplified signal is generated by using a second amplifier.

In an embodiment, the first amplified signal and the second amplified signals are generated by using a same programmable gain amplifier; and the first amplified signal and the second amplified signal are generated by alternating a gain setting of the programmable gain amplifier between at least the first gain and the second gain.

According to aspects of the disclosure, a sensor is provided, comprising: one or more sensing elements configured to generate a sensing signal; one or more amplifiers configured to: (i) amplify the sensing signal by using a first gain to produce, at least in part, a first amplified signal, the first amplified signal having a first offset, and (ii) amplify the sensing signal by using a second gain to produce, at least in part, a second amplified signal, the second amplified signal having a second offset; and a processing circuitry that is configured to: (i) generate an adjusted signal based on the first amplified signal, the second amplified signal, the first gain, and the second gain, the adjusted signal approximating a difference between the second amplified signal and an offset of the second amplified signal; and (ii) use the adjusted signal to generate an output of the sensor.

In an embodiment, the processing circuitry is further configured to retrieve, from a memory, an offset proportionality constant that is indicative of a ratio between the first offset and the second offset, and the adjusted signal is calculated further based on the offset proportionality constant.

In an embodiment, generating the adjusted signal includes calculating the second offset based on the first amplified signal, the second amplified signal, the first gain, and the second gain, and subtracting the second offset from the second amplified signal.

In an embodiment, calculating the adjusted signal includes calculating a ratio between (i) a difference between the first and second amplified signals and (ii) a difference between the first gain and the second gain.

In an embodiment, calculating the adjusted signal includes scaling the second amplified signal based on an offset proportionality constant to produce a scaled second amplified signal, scaling the second gain based on the offset proportionality constant to produce a scaled second gain, and calculating a ratio between (i) a difference between the first amplified signal and the scaled second amplified signal, and (ii) a difference between the second gain and the scaled second gain.

In an embodiment, generating the adjusted signal includes calculating the second offset based on the first amplified signal, the second amplified signal, the first gain, and the second gain, and subtracting the second offset from the second amplified signal, the second offset being calculated in accordance with the equation of:

$$V_{Q_2} = \frac{s_2 V_1 - s_1 V_2}{s_2 A - s_1}$$ where $V_{Q_2}$ is the second offset, $s_1$ is the first gain, $s_2$ is the second gain, $V_1$ is the first amplified signal, $V_2$ is the second amplified signal, $A$ is an offset proportionality constant that is indicative of a ration between the first amplified signal and the second amplified signal, and $A \geq 1$.

In an embodiment, the adjusted signal is calculated in accordance with the equation of:

$$V_{ADJ} = \frac{V_1 - A V_2}{s_1 - A s_2}$$ where $V_{ADJ}$ is the adjusted signal, $s_1$ is the first gain, $s_2$ is the second gain, $V_1$ is the first amplified signal, $V_2$ is the second amplified signal, $A$ is an offset proportionality constant that is indicative of a ration between the first amplified signal and the second amplified signal, and $A \geq 1$.

In an embodiment, each of the sensing elements includes a magnetic field sensing element.

In an embodiment, each of the sensing elements includes one of a strain gauge element, a thermistor, a photoresistor, a humidity sensing element, a gas sensing element, or a force sensing element.

In an embodiment, the one or more amplifiers include a first amplifier and a second amplifier, the first amplified signal is generated by using the first amplifier and the second amplified signal is generated by using the second amplifier.

In an embodiment, the one or more amplifiers include a programmable gain amplifier, the first amplified signal and the second amplified signals are both generated by using the programmable gain amplifier, and the first amplified signal and the second amplified signal are generated by alternating a gain setting of the programmable gain amplifier between at least the first gain and the second gain.

According to aspects of the disclosure, a system is provided, comprising: means for generating a sensing signal by using one or more sensing elements; means for amplifying the sensing signal by using a first gain to produce, at least in part, a first amplified signal, the first amplified signal having a first offset; means for amplifying the sensing signal by using a second gain to produce, at least in part, a second amplified signal, the second amplified signal having a second offset; and means for generating an adjusted signal based on the first amplified signal, the second amplified signal, the first gain, and the second gain, the adjusted signal approximating a difference between the second amplified signal and an offset of the first amplified signal.

According to aspects of the disclosure, a method for use in a sensor, comprising: generating a sensing signal by using one or more sensing elements; amplifying the sensing signal by using a first gain to produce, at least in part, a first amplified signal; amplifying the sensing signal by using a second gain to produce, at least in part, a second amplified signal, the second gain being smaller than the first gate; generating an adjusted signal based the first gain, the second gain, and at least one of the first amplified signal and the second amplified signal; and using the adjusted signal to generate an output of the sensor, wherein, when the second amplified signal is less than a threshold, generating the adjusted signal includes scaling the first amplified signal based on a ratio of the first gain and the second gain, and setting the adjusted signal to equal the scaled first amplified signal, and, when the second amplified signal is greater than or equal to the threshold, generating the adjusted signal includes setting the adjusted signal to equal the second amplified signal.

In an embodiment, the adjusted signal is generated in accordance with the equation of:

$$V_{ADJ} = \begin{cases} V_1 \dfrac{s_2}{s_1} & \text{for } V_2 < v_{max1} \\ V_2 & v_{max1} \leq V_2 \end{cases}$$ where $s_1$ is the first gain, $V_1$ is the first amplified signal, $s_2$ is the first gain $V_2$ is the first amplified signal, and $v_{max1}$ is the threshold.

In an embodiment, the first amplified signal is generated by using a first amplifier and the second amplified signal is generated by using a second amplifier.

In an embodiment, the first amplified signal and the second amplified signals are generated by using a same programmable gain amplifier, first amplified signal and the second amplified signal being generated by alternating a gain setting of the programmable gain amplifier between at least the first gain and the second gain.

According to aspects of the disclosure, a sensor is provided, comprising: one or more sensing elements configured to generate a sensing signal; one or more amplifiers configured to: (i) amplify the sensing signal by using a first gain to produce, at least in part, a first amplified signal, the first amplified signal having a first offset, and (ii) amplify the sensing signal by using a second gain to produce, at least in part, a second amplified signal, the second amplified signal having a second offset; and a processing circuitry that is configured to: (i) generate an adjusted signal based the first gain, the second gain, and at least one of the first amplified signal and the second amplified signal; and (ii) use the adjusted signal to generate an output of the sensor, wherein, when the second amplified signal is less than a threshold, generating the adjusted signal includes scaling the first amplified signal based on a ratio of the first gain and the second gain, and setting the adjusted signal to equal the scaled first amplified signal, and, when the second amplified signal is greater than or equal to the threshold, generating the adjusted signal includes setting the adjusted signal to equal the second amplified signal.

In an embodiment, the adjusted signal is generated in accordance with the equation of:

$$V_{ADJ} = \begin{cases} V_1 \frac{s_2}{s_1} & \text{for } V_2 < v_{max1} \\ V_2 & v_{max1} \leq V_2 \end{cases}$$

where $s_1$ is the first gain, $V_1$ is the first amplified signal, $s_2$ is the first gain $V_2$ is the first amplified signal, and $v_{max1}$ is the threshold.

In an embodiment, the one or more amplifiers include a first amplifier and a second amplifier, the first amplified signal is generated by using the first amplifier and the second amplified signal is generated by using the second amplifier.

In an embodiment, the one or more amplifiers include a programmable gain amplifier, the first amplified signal and the second amplified signals are both generated by using the programmable gain amplifier, and the first amplified signal and the second amplified signal are generated by alternating a gain setting of the programmable gain amplifier between at least the first gain and the second gain.

## BRIEF DESCRIPTION OF THE DRAWINGS

The foregoing features may be more fully understood from the following description of the drawings in which:

FIG. 1A is a diagram of an example of a sensor, according to aspects of the disclosure;

FIG. 1B is a diagram of an example of a sensor, according to aspects of the disclosure;

FIG. 1C is a graph illustrating aspects of the operation of a sensor, according to aspects of the disclosure;

FIG. 2A is a flowchart of an example of a process, according to aspects of the disclosure;

FIG. 2B is a flowchart of an example of a process, according to aspects of the disclosure;

FIG. 2C is a flowchart of an example of a process, according to aspects of the disclosure; and

FIG. 3 is a diagram of an example of a sensor, according to aspects of the disclosure;

## DETAILED DESCRIPTION

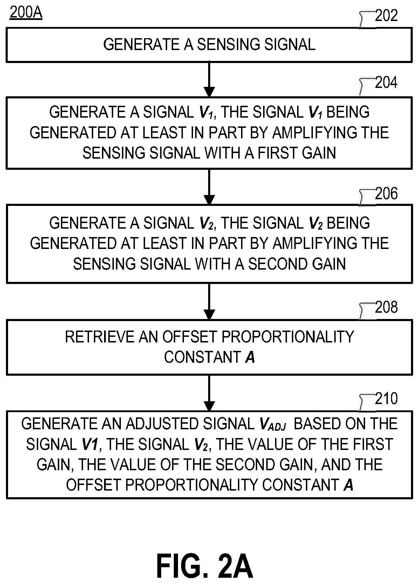

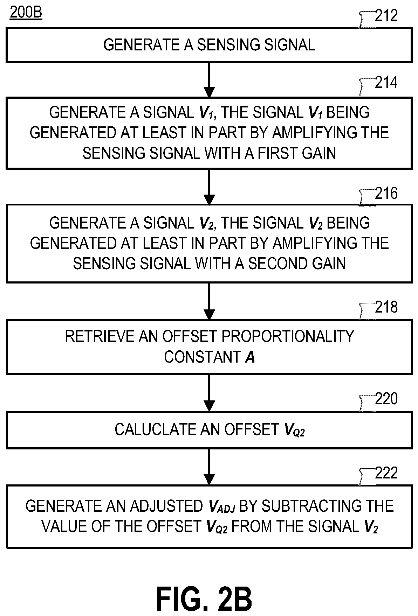

According to aspects of the disclosure, a sensor is provided that is configured to measure a physical quantity by utilizing two or more sensitivities concurrently. In some implementations, the sensor may be an integrated current sensor, simultaneously measuring current through two distinct sensitivities or internal amplifier gains. Specifically, the sensor may implement a method for dynamically correcting the zero-current offset voltage by employing the simultaneous measurement of current through two different sensitivities. The method may be executed as discussed further below with respect to FIG. 2A and/or FIG. 2B. Using the method is advantageous because it may eliminate (or at least reduce) the need for zero-input offset calibration in the sensor or the necessity for quiescent voltage trimming. This is in contrast to conventional sensors which require the zero-input signal to be measured and trimmed to a desired value at the time of the sensor's calibration.

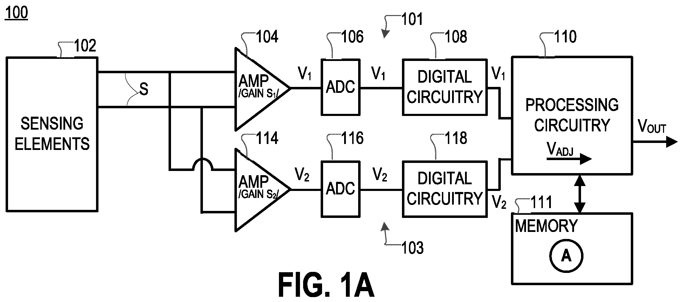

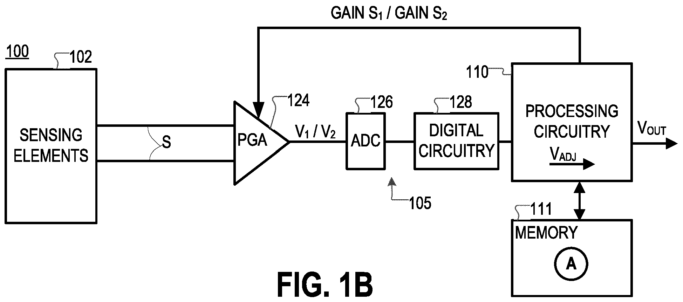

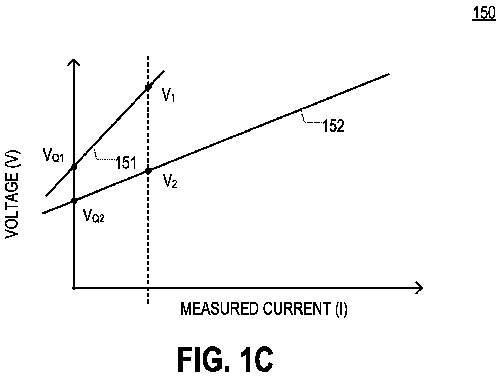

FIG. 1 is a diagram of a magnetic field sensor 100, according to aspects of the disclosure. According to the present example, sensor 100 is a current sensor. However, the present disclosure is not limited to sensor 100 being any specific type of sensor. As illustrated, sensor 100 may include sensing elements 102, signal paths 101 and 103, processing circuitry 110, and a memory 111. Signal path 101 may include an amplifier 104, an analog-to-digital converter (ADC) 106, digital circuitry 108, and a processing circuitry 110. Signal path 103 may include an amplifier 114, an ADC 116, and digital circuitry 118.

According to the present example, sensing elements 102 include one or more Hall plates. However, alternative implementations are possible in which the sensing elements 102 include one or more giant magnetoresistance (GMR) elements, one or more tunneling magnetoresistance (TMR) elements, and/or any other suitable type of sensing element. The digital circuitry 108 may include one or more of a cascaded integrator-comb (CIC) filter, a temperature correction circuit, a temperature sensor, a bandwidth selection circuit, and or any other suitable type of electronic circuitry that is used in digital sensors. The digital circuitry 118 may include one or more of a cascaded integrator-comb (CIC) filter, a temperature correction circuit, a temperature sensor, a bandwidth selection circuit, and or any other suitable type of electronic circuitry that is used in digital sensors. The processing circuitry 110 may include a general-purpose processor, an application-specific processor, and/or any other suitable type of processing circuitry. Memory 111 may include an Electrically Erasable Programmable Read-Only Memory (EEPROM), and/or any other suitable type of volatile or non-volatile memory.

In operation, sensing elements 102 may generate a sensing signal S. Amplifier 104 may amplify the sensing signal S with a first gain $S_1$ to generate a first signal $V_1$. ADC 106 may amplify the signal $V_1$. Digital circuitry 108 may perform filtering and/or other processing on the signal $V_1$. Processing circuitry 110 may receive the signal $V_1$ after it has been digitized and processed by ADC 106 and digital circuitry 108, respectively. Amplifier 114 may amplify the sensing signal S with a second gain $S_2$ to generate a SECOND signal $V_2$. ADC 116 may amplify the signal $V_2$. Digital circuitry 118 may perform filtering and/or other processing on the signal $V_2$. Processing circuitry 110 may receive the signal $V_2$ after it has been digitized and processed by ADC 116 and digital circuitry 118, respectively. Processing circuitry 110 may process signals $V_1$ and $V_2$ to generate a signal Vout. Signal Vout may be generated in accordance with one of processes 200A and 200B, which are discussed further below with respect to FIGS. 2A and 2B, respectively. According to the present example, signal Vout is output by sensor 100 to another device. However, alternative implementations are possible in which signal Vout is processed internally by sensor 100 to generate another output signal. Stated succinctly, the present disclosure is not limited to any specific method for using signal Vout.

FIG. 1B is a diagram of sensor 100, according to another implementation. The implementation of sensor 100 that is shown in FIG. 1B is nearly identical to the implementation shown in FIG. 1A, but for including a signal path 105 instead of signal paths 101 and 103. As illustrated, signal path 105 may include a programmable gain amplifier (PGA) 124, an ADC 126, and digital circuitry 128. Digital circuitry 128 may include one or more of a cascaded integrator-comb (CIC) filter, a temperature correction circuit, a temperature sensor, a bandwidth selection circuit, and or any other suitable type of electronic circuitry that is used in digital sensors.

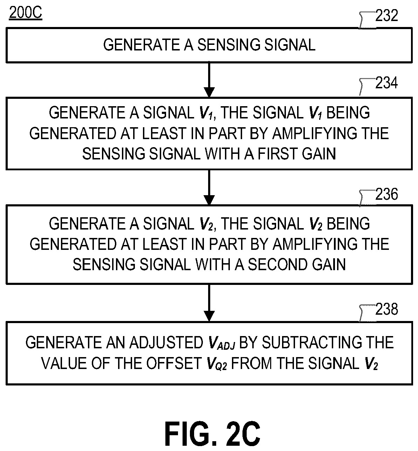

Processing circuitry 110 may be configured to set the gain of PGA 124. In operation, processing circuitry 110 may alternate the gain of PGA 124 between the gain $S_1$ and the gain $S_2$. PGA 124 may receive the sensing signal S from sensing elements $S_2$. When the gain of PGA 124 is set to $S_1$, PGA 124 may generate a signal $V_1$ and provide the signal $V_1$ to ADC 126; ADC 126 may digitize the signal $V_1$ and provide the digitized signal $V_1$ to digital circuitry 128. Digital circuitry 128 may process the signal $V_1$ and provide the processed signal $V_1$ to processing circuitry 110. When the gain of PGA 124 is set to $S_2$, PGA 124 may generate a signal $V_2$ and provide the signal $V_2$ to ADC 126; ADC 126 may digitize the signal $V_2$ and provide the digitized signal $V_2$ to digital circuitry 128. Digital circuitry 128 may process the signal $V_2$ and provide the processed signal $V_2$ to processing circuitry $V_2$. In the example of FIG. 2, signal $V_1$ includes samples of the output of PGA 124 when the gain of PGA 124 is set to $S_1$ and signal $V_2$ includes samples of the output of PGA 124 when the gain of PGA 124 is set to $S_2$. In some implementations, the gain of PGA 124 may alternate between $S_1$ and $S_2$ at a frequency of at least double the bandwidth of the sensor.

Processing circuitry 110 may process signals $V_1$ and $V_2$ to generate a signal Vout. Signal Vout may be generated in accordance with one of processes 200A and 200B, which are discussed further below with respect to FIGS. 2A and 2B, respectively. According to the present example, signal Vout is output by sensor 100 to another device. However, alternative implementations are possible in which signal Vout is processed internally by sensor 100 to generate another output signal. Stated succinctly, the present disclosure is not limited to any specific method for using signal Vout.

FIG. 1C shows an example of graph 150, which includes curves 151 and 152. Curve 151 is a plot of signal $V_1$ and curve 152 is a plot of signal $V_2$. The X-axis of graph 150 represents the value I of the electrical current that is being measured by sensor 100. In the example of FIG. 1, the slope of curve 151 is equal to (or otherwise based on) the gain $S_1$, and the slope of signal $V_2$ is equal to, or otherwise based on, the gain $S_1$. In the example of FIG. 1C, signal $V_1$ has an offset $V_{Q1}$ and signal $V_2$ has an offset $V_{Q2}$.

The offsets $V_{Q1}$ and $V_{Q2}$ may be present in the signals $V_1$ and $V_2$, respectively, for various reasons, such as impurities in the materials used to form the sensing elements 102, device geometry and fabrication, magnetic field homogeneity, and others. The presence of such offsets in the signals produced by sensing elements can result introduce inaccuracies in the measurements that are produced by sensing elements (or sensors utilizing the sensing elements). For this reason, magnetic field sensors (as well as other types of sensors) employ various techniques that remove the offset from the signals produced by the sensing elements before the signals are used to produce an output signal.

Processing circuitry 110 employs a process for removing offset from the signals produced by sensing elements by measuring electrical current using two sensitivities at the same time. The two sensitivities that are referred to as the gains $S_1$ and $S_2$, which are discussed above with respect to FIGS. 1A-B. The removal of offset is accomplished by using an improved model which is further discussed further below.

According to the model, the values of signals $V_1$ and $V_2$ can be represented by equations 1 and 2 below:

$$V_1 = I \cdot s_1 + V_{Q1} \quad (1)$$

$$V_2 = I \cdot s_2 + V_{Q2} \quad (2)$$

where I is the value of the signal being measured, $S_1$ is the first gain with which the signal S (shown in FIGS. 1A-B) is being amplified, and $S_2$ is the second gain with which the signal S (shown in FIGS. 1A-B) is being amplified, the value of $S_1$ is different from the value of $S_2$ ($s_1 \neq s_2$), $V_{Q1}$ is the offset that is present in signal $V_1$ and $V_{Q2}$ is the offset that is present in signal $V_2$. In one example, the values of signals $V_1$ and $V_2$ in equations 1 and 2 may be generated simultaneously and they may measure the same electrical current value (e.g., see FIG. 1A). In this example, signals $V_1$ and $V_2$ may be generated by amplifying the signal using different amplifiers that have different gains (e.g., amplifiers 104 and 114 both of which are shown in FIG. 1A). Alternatively, signals $V_1$ and $V_2$ may be generated by using the same amplifier (e.g., amplifier 114 that is shown in FIG. 1B), while switching the gain of the amplifier very rapidly. In this case, the values of signals $V_1$ and $V_2$, which are referenced in equations 1 and 2, may be consecutive samples of the output of the amplifier or samples of the output of the amplifier that are captured during the same time window (e.g., a time window having a duration of 50 ms, etc.). In any event, the samples may be captured so closely in time with each other that for the purposes of the present disclosure they are presumed to represent the same electrical current level.

Equations 1 and 2 lead to the identity which is described by equation 3 below:

$$\frac{V_1 - V_{Q1}}{s_1} = \frac{V_2 - V_{Q2}}{s_2} \quad (3)$$

An offset proportionality constant may be defined by Equation 4 as follows:

$$A = \frac{V_{Q1}}{V_{Q2}} \quad (4)$$

Using equations 1-4, the values of the offsets $V_{Q1}$ and $V_{Q2}$ may be described by equations 5 and 6 below:

$$V_{Q_1} = A \frac{s_2 V_1 - s_1 V_2}{s_2 A - s_1} \quad (5)$$

$$V_{Q_2} = \frac{s_2 V_1 - s_1 V_2}{s_2 A - s_1} \quad (6)$$

Using Equations 1-6, the offset $V_{Q2}$ may be removed from signal $V_2$ by using Equation 7 below:

$$V_{ADJ} = \frac{V_2 - V_{Q2}}{s_2} = \frac{V_1 - A V_2}{s_1 - A s_2} \quad (7)$$

Equation 7 provides that signal $V_{ADJ}$ is equal to the value of signal $V_2$ with the offset $v_{Q2}$ removed from it. Equation 7 further provides that the value of signal $V_{ADJ}$ is equal to the quotient of (i) the difference between the value of signal $V_2$ and the value of signal $V_1$ as scaled by the offset proportionality constant A, and (ii) the difference between the first gain $S_1$ and the second gain $S_2$, as scaled by offset proportionality constant A. In some implementations, the signal VOUT (shown in FIGS. 1A-B) may be the same or equal to the adjusted signal $V_{ADJ}$. Alternatively, in some implementations, the signal VOUT may be another signal that is generated in part based on the signal $V_{ADJ}$.

Returning to FIGS. 1A-B, the value of the proportionality constant A may be stored in memory 111. In some implementations, the value of the proportionality constant A may be stored in memory 111 at the factory, and it may be one of the many factory-specified configuration settings of sensor 100. Alternatively, in some implementations, the value of the proportionality constant A may be stored in memory 111 as a result of sensor 100 executing a calibration procedure. The calibration procedure may be performed by sampling the output of sensing elements 102 while no detectable electrical current is present in the vicinity of sensor 100. Moreover, according to the present disclosure, it has been determined that in many practical sensor layouts (i.e., die layouts) the offset proportionality constant may be equal to 1 or be sufficiently close to the value of 1. In other words, in many implementations, it may be possible to omit the value of the proportionality constant A from the calculations described above with respect to equations 1-7.

In some implementations, processing circuitry 110 may execute at least a portion of a process 200A (discussed below with respect to FIG. 2A), which takes advantage of the model described above with respect to equations 1-7. Additionally or alternatively, in some implementations, processing circuitry 110 may execute at least a portion of a process 200B (discussed below with respect to FIG. 2B), which takes advantage of the model described above with respect to equations 1-7. Additionally or alternatively, in some implementations, processing circuitry 110 may execute at least a portion of a process 200C (discussed with respect to FIG. 2C), which capitalizes on the fact that signals $V_1$ and $V_2$ have different sensitivities.

FIG. 2A is a flowchart of an example of a process 200A, according to aspects of the disclosure. According to the present example, process 200A is performed by sensor 100. However, the present disclosure is not limited to any specific entity executing the process 200A. In some respects, incorporating process 200A into the operation of a sensor is advantageous because it may eliminate the need for zero-input calibration and/or quiescent voltage trimming.

At step 202, a sensing signal is generated by using one or more sensing elements. According to the present example, the sensing signal is the signal S, which is discussed above with respect to FIGS. 1A-B and it is generated by sensing elements 102. Although in the present example, sensing signal S is generated by magnetic field sensing elements, alternative implementations are possible in which the sensing signal S is generated by another type of sensing element, such as a strain gauge, a thermistor, a light-dependent resistor (LDR), a humidity sensing element, a gas sensor, a force-sensitive resistor, or a flex-sensor. Stated succinctly, the present disclosure is not limited to any specific type of sensing element (or a plurality of sensing elements) being used to generate the sensing signal.

At step 204, a first signal $V_1$ is generated by amplifying the sensing signal (generated at step 202) with a first gain $S_1$. In some implementations, the signal $V_1$ may be generated in the manner discussed above with respect to FIGS 1A-B.

At step 206, a second signal $V_2$ is generated by amplifying the sensing signal with a second gain $S_2$. In some implementations, the signal $V_2$ may be generated in the manner discussed above with respect to FIGS 1A-B.

At step 208, an offset proportionality constant A is retrieved from a memory. The offset proportionality constant A may be determined based on the first gain $S_1$ and the second gain $S_2$. In some implementations, the offset proportionality constant A may be calculated in accordance with Equation 4.

At step 210, an adjusted signal $V_{ADJ}$ may be calculated based on equation 7. Specifically, the adjusted signal $V_{ADJ}$ may be calculated by evaluating the expression of $\frac{V_1 - AV_2}{S_1 - AS_2}$, which discussed above with respect to equation 7, where $V_1$ is the value of the first signal, $V_2$ is the value of the second signal, A is the value of the offset proportionality constant (retrieved at step 208), and $S_1$ is the first gain that is used generate signal $V_1$, and $S_2$ is the second gain that is used to generate signal $V_2$.

As noted above, the adjusted signal $V_{ADJ}$ may be equal (or sufficiently close to being equal) to the value of signal $V_2$ with the offset $V_{Q2}$ removed. Calculating the adjusted signal $V_{ADJ}$ in the discussed manner, however, does not require an exact knowledge of the value of signal $V_{Q1}$.

After the adjusted signal $V_{ADJ}$ is generated it may be output from sensor 100 to external circuitry that is utilizes the measurements taken from sensor 100. For example, the signal $V_{ADJ}$ may be output to the electronic control unit (ECU) of an electric vehicle and/or to another controller. Alternatively, the adjusted signal $V_{ADJ}$ may be used as any offset-adjusted signal would be in the prior art to generate an output signal that is subsequently provided to external circuitry. Stated succinctly, the present disclosure is not limited to any specific method for using the adjusted signal $V_{ADJ}$.

FIG. 2B is a flowchart of an example of a process 200B, according to aspects of the disclosure. According to the present example, process 200B is performed by sensor 100. However, the present disclosure is not limited to any specific entity executing the process 200A. In some respects, incorporating process 200B into the operation of a sensor is advantageous because it may eliminate the need for zero-input calibration and/or quiescent voltage trimming.

At step 212, a sensing signal is generated by using one or more sensing elements. According to the present example, the sensing signal is the signal S, which is discussed above with respect to FIGS. 1A-B and it is generated by sensing elements 102. Although in the present example, sensing signal S is generated by magnetic field sensing elements, alternative implementations are possible in which the sensing signal S is generated by another type of sensing element, such as a strain gauge, a thermistor, a light-dependent resistor (LDR), a humidity sensing element, a gas sensor, a force-sensitive resistor, or a flex-sensor. Stated succinctly, the present disclosure is not limited to any specific type of sensing element (or a plurality of sensing elements) being used to generate the sensing signal.

At step 214, a first signal $V_1$ is generated by amplifying the sensing signal (generated at step 212) with a first gain $S_1$. In some implementations, the signal $V_1$ may be generated in the manner discussed above with respect to FIGS 1A-B.

At step 216, a second signal $V_2$ is generated by amplifying the sensing signal with a second gain $S_2$. In some implementations, the signal $V_2$ may be generated in the manner discussed above with respect to FIGS 1A-B.

At step 218, an offset proportionality constant A is retrieved from memory.

At step 220, the offset of the second signal $V_2$ is calculated based on the offset proportionality constant A, the first gain $S_1$, the second gain $S_2$, the first signal $V_1$, and the second signal $V_2$. In some implementations, the value of the offset of the second signal $V_2$ may be calculated by using equation 6.

At step 222, an adjusted signal $V_{ADJ}$ may be calculated by subtracting the offset (calculated at step 220) from the value of signal $V_2$ (obtained at step 216). After the adjusted signal $V_{ADJ}$ is generated it may be output from sensor 100 to external circuitry that utilizes the measurements taken from sensor 100. For example, the signal $V_{ADJ}$ may be output to the electronic control unit (ECU) of an electric vehicle and/or to another controller. Alternatively, the adjusted signal $V_{ADJ}$ may be used as any offset-adjusted signal would be in the prior art to generate an output signal that is subsequently provided to external circuitry. Stated succinctly, the present disclosure is not limited to any specific method for using the adjusted signal $V_{ADJ}$.

FIG. 2C is a flowchart of an example of a process 200C, according to aspects of the disclosure. According to the present example, process 200C is performed by sensor 100. However, the present disclosure is not limited to any specific entity executing the process 200C. In some respects, incorporating process 200C into the operation of a sensor is advantageous because it may increase the dynamic range of the sensor.

At step 232, a sensing signal is generated by using one or more sensing elements. According to the present example, the sensing signal is the signal S, which is discussed above with respect to FIGS. 1A-B and it is generated by sensing elements 102. Although in the present example, sensing signal S is generated by magnetic field sensing elements, alternative implementations are possible in which the sensing signal S is generated by another type of sensing element, such as a strain gauge, a thermistor, a light-dependent resistor (LDR), a humidity sensing element, a gas sensor, a force-sensitive resistor, or a flex-sensor. Stated succinctly, the present disclosure is not limited to any specific type of sensing element (or a plurality of sensing elements) being used to generate the sensing signal.

At step 234, a first signal $V_1$ is generated by amplifying the sensing signal (generated at step 232) with a first gain $S_1$. In some implementations, the signal $V_1$ may be generated in the manner discussed above with respect to FIGS 1A-B.

At step 236, a second signal $V_2$ is generated by amplifying the sensing signal with a second gain $S_2$. In some implementations, the signal $V_2$ may be generated in the manner discussed above with respect to FIGS 1A-B.

At step 238, an adjusted signal $V_{ADJ}$ is generated based on signals $V_1$ and $V_2$. In some implementations, the adjusted signal $V_{ADJ}$ may be calculated in accordance with equation 8 below:

$$V_{ADJ} = \begin{cases} V_1 \frac{s_2}{s_1} & \text{for } V_2 < v_{max1} \\ V_2 & v_{max1} \le V_2 < v_{max2} \end{cases} \quad (8)$$

where the gain at which the signal $V_1$ is amplified, $S_2$ is the gain at which signal $V_2$ is amplified, $v_{max1}$ is a maximum voltage output associated with signal $V_1$, and $v_{max2}$ is a maximum voltage output associated with signal $V_2$. When signals $V_1$ and $V_2$ are generated with two different amplifiers, such as amplifiers 104 and 114 (shown in FIG. 1A), $v_{max1}$ may be the maximum voltage output of the amplifier that is used to generate signal $V_1$ (e.g., amplifier 104) and $v_{max2}$ may be the maximum voltage output of the amplifier used to generate signal $V_2$ (e.g., amplifier 114). In implementations when a PGA is used to generate both of signals $V_1$ and $V_2$, such as PGA 124 (shown in FIG. 1B), $v_{max1}$ may be the maximum voltage of the PGA when the gain of the PGA is set to $S_1$, and $v_{max2}$ may be the gain of the maximum voltage output of the PGA when the gain of the PGA is set to $S_2$. According to the present example, the value of $v_{max1}$ is smaller than the value of $v_{max2}$, and the value of $S_1$ is greater than the value of $S_2$ (i.e., $v_{max1} < v_{max2}$ and $S_1 > S_2$).

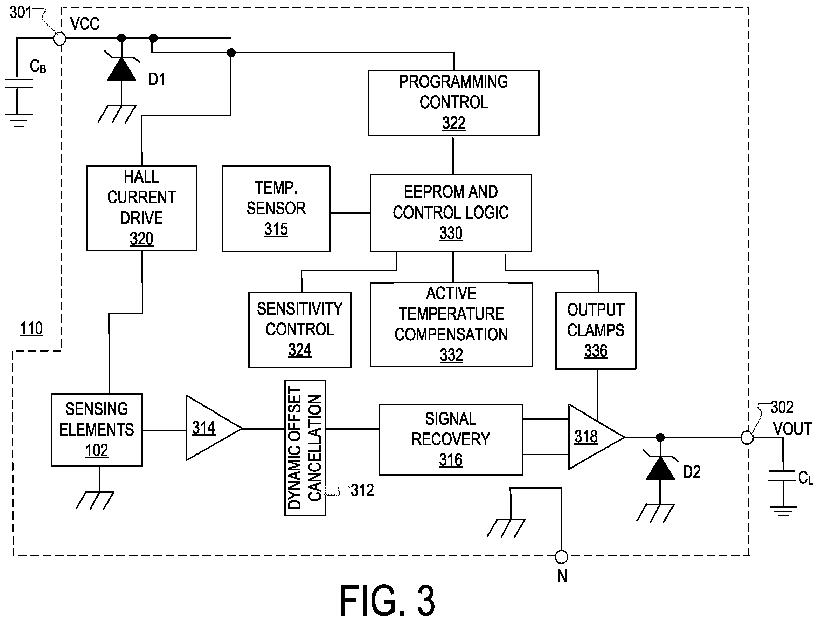

FIG. 3 is a circuit diagram illustrating yet another implementation of sensor 100, according to aspects of the disclosure. In the example, of FIG. 3, sensor 100 is a current sensor and it may be configured to output a signal VOUT that is proportional to $\Delta B = B_R - B_L$ where $B_R$ represents the magnetic field incident on one of the magnetic field sensing elements 102 and $B_L$ represents magnetic field incident on the other one of the magnetic field sensing elements 102. The sensor output VOUT is also affected by the sensitivity, $\alpha$, of the signal path and can be represented as follows:

$$VOUT = \alpha \times \Delta B \quad (9)$$

The relationship between the conductor current to be measured and the differential field $\Delta B$ can be represented by a coupling coefficient, $K(f)$ as follows:

$$\Delta B = K(f) \times I \quad (10)$$

It will be appreciated that coupling coefficient $K(f)$ corresponds to coupling (e.g., transfer of energy, etc.) between a given current sensor and varies with frequency.

The sensor 100 may include a VCC (supply voltage) pin 301, a VOUT (output signal) pin 302. The VCC pin 301 is used for the input power supply or supply voltage for the sensor 100. A bypass capacitor, $C_B$, can be coupled between the VCC pin 301 and ground. The VCC pin 301 can also be used for programming the sensor 100. The VOUT pin 302 is used for providing the output signal VOUT to external circuits and systems (not shown). An output load capacitance $C_L$ is coupled between the VOUT pin 302 and ground. According to the present example, sensor 100 can include a first diode D1 coupled between the VCC pin 301 and chassis ground and a second diode D2 coupled between the VOUT pin 302 and chassis ground.

The driver circuit 320 may be configured to drive the magnetic field sensing elements 102. Magnetic field signals generated by the magnetic field sensing elements 102 are coupled to a dynamic offset cancellation circuit 312, which is further coupled to an amplifier 314. The amplifier 314 is configured to generate an amplified signal for coupling to the signal recovery circuit 316. Dynamic offset cancellation circuit 312 may take various forms including processing circuitry that is configured to implement at least in part one of processes 200A-C, which are discussed above with respect to FIGS. 2A-C, respectively. Although dynamic offset cancelation circuit 312 and EEPROM and control logic 330 are depicted as separate entities, in some implementations they may be at least partially integrated with each other. In some implementations, amplifier 314 may be a programmable gain amplifier, and sensitivity control circuit 324 may alternate the gain of amplifier 314 between the values $S_1$ and $S_2$, which are discussed above with respect to FIG. 1. In such implementations, dynamic offset cancelation circuit 312 may execute one of processes 200A or 200B to correct the offset in the output of amplifier 314. A regulator (not shown) can be coupled between the supply voltage VCC and ground and to the various components and sub-circuits of the sensor 100 to regulate the supply voltage.

A programming control circuit 322 is coupled between the VCC pin 301 and EEPROM and control logic circuit 330 to provide appropriate control to the EEPROM and control logic circuit. EEPROM and control logic circuit 330 determines any application-specific coding and can be erased and reprogrammed using a pulsed voltage. A sensitivity control circuit 324 can be coupled to the amplifier 314 to generate and provide a sensitivity control signal to the amplifier 314 to adjust the sensitivity and/or operating voltage of the amplifier 314. An active temperature compensation circuit 332 can be coupled to sensitivity control circuit 324, EEPROM and control logic circuit 330, and offset control circuit 334. A push/pull driver circuit 318 (which may be an amplifier) may place the output of the signal recovery circuit 316 on the VOUT pin 302. The active temperature compensation circuit 332 can acquire temperature data from EEPROM and control logic circuit 330 via a temperature sensor 315 and perform necessary calculations to compensate for changes in temperature, if needed. Output clamps circuit 336 can be coupled between the EEPROM and control logic circuit 330 and the driver circuit 318 to limit the output voltage and for diagnostic purposes.

The concepts and ideas presented throughout the disclosure are not limited to current sensor or magnetic field sensors. The concepts and ideas presented throughout the disclosure can be applied to any suitable type of sensor that uses one or more sensing elements. Examples of sensing elements whose output can be corrected by suing the above-discussed concepts and ideas include a strain gauge, a thermistor, a light-dependent resistor (LDR), a humidity sensing element, a gas sensor, a force-sensitive resistor, or a flex-sensor. Stated succinctly, the present disclosure is not limited to the sensors 102 (shown in FIGS. 1A-B) being magnetic field sensors.

A magnetic-field sensing element can be, but is not limited to, a Hall Effect element a magnetoresistance element, or an inductive coil. As is known, there are different types of Hall Effect elements, for example, a vertical Hall element, and a Circular Vertical Hall (CVH) element. As is also known, there are different types of magnetoresistance elements, for example, a semiconductor magnetoresistance element such as Indium Antimonide (InSb), a giant magnetoresistance (GMR) element, an anisotropic magnetoresistance element (AMR), a tunneling magnetoresistance (TMR) element, and a magnetic tunnel junction (MTJ). The magnetic field sensing element may be a single element or, alternatively, may include two or more magnetic field sensing elements arranged in various configurations, e.g., a half bridge or full (Wheatstone) bridge. Depending on the device type and other application requirements, the magnetic field sensing element may be a device made of a type IV semiconductor material such as Silicon (Si) or Germanium (Ge), or a type III-V semiconductor material like Gallium-Arsenide (GaAs) or an Indium compound, e.g., Indium-Antimonide (InSb). The phrase "set of magnetic field elements" shall mean "one or more magnetic field sensing elements". For example, and without limitation, each or any of sensing elements 102 may include any of the listed magnetic field sensing element types.

The concepts and ideas described herein may be implemented, at least in part, via a computer program product, (e.g., in a non-transitory machine-readable storage medium such as, for example, a non-transitory computer-readable medium), for execution by, or to control the operation of, data processing apparatus (e.g., a programmable processor, a computer, or multiple computers). Each such program may be implemented in a high-level procedural or object-oriented programming language to work with the rest of the computer-based system. However, the programs may be implemented in assembly, machine language, or Hardware Description Language. The language may be a compiled or an interpreted language, and it may be deployed in any form, including as a stand-alone program or as a module, component, subroutine, or another unit suitable for use in a computing environment. A computer program may be deployed to be executed on one computer or multiple computers at one site or distributed across multiple sites and interconnected by a communication network. A computer program may be stored on a non-transitory machine-readable medium that is readable by a general or special-purpose programmable computer for configuring and operating the computer when the non-transitory machine-readable medium is read by the computer to perform the processes described herein. For example, the processes described herein may also be implemented as a non-transitory machine-readable storage medium, configured with a computer program, where upon execution, instructions in the computer program cause the computer to operate in accordance with the processes. A non-transitory machine-readable medium may include but is not limited to a hard drive, compact disc, flash memory, non-volatile memory, or volatile memory. The term unit (e.g., an addition unit, a multiplication unit, etc.), as used throughout the disclosure may refer to hardware (e.g., an electronic circuit) that is configured to perform a function (e.g., addition or multiplication, etc.), software that is executed by at least one processor, and configured to perform the function, or a combination of hardware and software.

Also, for purposes of this description, the terms "couple," "coupling," "coupled," "connect," "connecting," or "connected" refer to any manner known in the art or later developed in which energy is allowed to be transferred between two or more elements, and the interposition of one or more additional elements is contemplated, although not required. Conversely, the terms "directly coupled," "directly connected," etc., imply the absence of such additional elements.

As used herein in reference to an element and a standard, the term "compatible" means that the element communicates with other elements in a manner wholly or partially specified by the standard, and would be recognized by other elements as sufficiently capable of communicating with the other elements in the manner specified by the standard. The compatible element does not need to operate internally in a manner specified by the standard.

Having described preferred embodiments, which serve to illustrate various concepts, structures and techniques, which are the subject of this patent, it will now become apparent that other embodiments incorporating these concepts, structures and techniques may be used. Accordingly, it is submitted that the scope of the patent should not be limited to the described embodiments but rather should be limited only by the spirit and scope of the following claims.

## Claims

1. A method for use in a sensor, comprising:

   generating a sensing signal by using one or more sensing elements;
   amplifying the sensing signal by using a first gain to produce, at least in part, a first amplified signal, the first amplified signal having a first offset;
   amplifying the sensing signal by using a second gain to produce, at least in part, a second amplified signal, the second amplified signal having a second offset;
   generating an adjusted signal based on the first amplified signal, the second amplified signal, the first gain, and the second gain, the adjusted signal approximating a difference between the second amplified signal and an offset of the second amplified signal; and
   using the adjusted signal to generate an output of the sensor.

2. The method of claim 1, further comprising, retrieving, from a memory, an offset proportionality constant that is indicative of a ratio between the first offset and the second offset, wherein the adjusted signal is calculated further based on the offset proportionality constant.

3. The method of claim 1, wherein the first amplified signal is generated by using a first amplifier and the second amplified signal is generated by using a second amplifier.

4. The method of claim 1, wherein:

   the first amplified signal and the second amplified signals are generated by using a same programmable gain amplifier; and
   the first amplified signal and the second amplified signal are generated by alternating a gain setting of the programmable gain amplifier between at least the first gain and the second gain.

5. A sensor, comprising:

   one or more sensing elements configured to generate a sensing signal;
   one or more amplifiers configured to: (i) amplify the sensing signal by using a first gain to produce, at least in part, a first amplified signal, the first amplified signal having a first offset, and (ii) amplify the sensing signal by using a second gain to produce, at least in part, a second amplified signal, the second amplified signal having a second offset; and
   a processing circuitry that is configured to: (i) generate an adjusted signal based on the first amplified signal, the second amplified signal, the first gain, and the second gain, the adjusted signal approximating a difference between the second amplified signal and an offset of the second amplified signal; and (ii) use the adjusted signal to generate an output of the sensor.

6. The sensor of claim 5, wherein:

   the processing circuitry is further configured to retrieve, from a memory, an offset proportionality constant that is indicative of a ratio between the first offset and the second offset, and
   the adjusted signal is calculated further based on the offset proportionality constant.

7. The sensor of claim 5, or the method of claim 1, wherein generating the adjusted signal includes calculating the second offset based on the first amplified signal, the second amplified signal, the first gain, and the second gain, and subtracting the second offset from the second amplified signal.

8. The sensor of claim 5, or the method of claim 1, wherein calculating the adjusted signal includes calculating a ratio between (i) a difference between the first and second amplified signals and (ii) a difference between the first gain and the second gain.

9. The sensor of claim 5, or the method of claim 1, wherein calculating the adjusted signal includes scaling the second amplified signal based on an offset proportionality constant to produce a scaled second amplified signal, scaling the second gain based on the offset proportionality constant to produce a scaled second gain, and calculating a ratio between (i) a difference between the first amplified signal and the scaled second amplified signal, and (ii) a difference between the second gain and the scaled second gain.

10. The sensor of claim 5, or the method of claim 1, wherein generating the adjusted signal includes calculating the second offset based on the first amplified signal, the second amplified signal, the first gain, and the second gain, and subtracting the second offset from the second amplified signal, the second offset being calculated in accordance with the equation of:

$$V_{Q_2} = \frac{s_2 V_1 - s_1 V_2}{s_2 A - s_1}$$

where $V_{Q_2}$ is the second offset, $s_1$ is the first gain, $s_2$ is the second gain, $V_1$ is the first amplified signal, $V_2$ is the second amplified signal, $A$ is an offset proportionality constant that is indicative of a ration between the first amplified signal and the second amplified signal, and $A \geq 1$.

11. The sensor of claim 5, or the method of claim 1, wherein the adjusted signal is calculated in accordance with the equation of:

$$V_{ADJ} = \frac{V_1 - A V_2}{s_1 - A s_2}$$

where $V_{ADJ}$ is the adjusted signal, $s_1$ is the first gain, $s_2$ is the second gain, $V_1$ is the first amplified signal, $V_2$ is the second amplified signal, $A$ is an offset proportionality constant that is indicative of a ration between the first amplified signal and the second amplified signal, and $A \geq 1$.

12. The sensor of claim 5, or the method of claim 1, wherein each of the sensing elements includes a magnetic field sensing element.

13. The sensor of claim 5, or the method of claim 1, wherein each of the sensing elements includes one of a strain gauge element, a thermistor, a photoresistor, a humidity sensing element, a gas sensing element, or a force sensing element.

14. The sensor of claim 5, wherein the one or more amplifiers include a first amplifier and a second amplifier, the first amplified signal is generated by using the first amplifier and the second amplified signal is generated by using the second amplifier.

15. The sensor of claim 5, wherein the one or more amplifiers include a programmable gain amplifier, the first amplified signal and the second amplified signals are both generated by using the programmable gain amplifier, and the first amplified signal and the second amplified signal are generated by alternating a gain setting of the programmable gain amplifier between at least the first gain and the second gain.

16. A system, comprising:

means for generating a sensing signal by using one or more sensing elements;
means for amplifying the sensing signal by using a first gain to produce, at least in part, a first amplified signal, the first amplified signal having a first offset;
means for amplifying the sensing signal by using a second gain to produce, at least in part, a second amplified signal, the second amplified signal having a second offset; and
means for generating an adjusted signal based on the first amplified signal, the second amplified signal, the first gain, and the second gain, the adjusted signal approximating a difference between the second amplified signal and an offset of the second amplified signal.

17. A method for use in a sensor, comprising:

generating a sensing signal by using one or more sensing elements;
amplifying the sensing signal by using a first gain to produce, at least in part, a first amplified signal;
amplifying the sensing signal by using a second gain to produce, at least in part, a second amplified signal, the second gain being smaller than the first gain;
generating an adjusted signal based the first gain, the second gain, and at least one of the first amplified signal and the second amplified signal; and
using the adjusted signal to generate an output of the sensor,
wherein, when the second amplified signal is less than a threshold, generating the adjusted signal includes scaling the first amplified signal based on a ratio of the first gain and the second gain, and setting the adjusted signal to equal the scaled first amplified signal, and, when the second amplified signal is greater than or equal to the threshold, generating the adjusted signal includes setting the adjusted signal to equal the second amplified signal.

18. The method of claim 17, wherein the first amplified signal is generated by using a first amplifier and the second amplified signal is generated by using a second amplifier.

**19.** The method of claim 17, wherein the first amplified signal and the second amplified signal are generated by using a same programmable gain amplifier, the first amplified signal and the second amplified signal being generated by alternating a gain setting of the programmable gain amplifier between at least the first gain and the second gain.

**20.** A sensor, comprising:

one or more sensing elements configured to generate a sensing signal;
one or more amplifiers configured to: (i) amplify the sensing signal by using a first gain to produce, at least in part, a first amplified signal, the first amplified signal having a first offset, and (ii) amplify the sensing signal by using a second gain to produce, at least in part, a second amplified signal, the second amplified signal having a second offset; and
a processing circuitry that is configured to: (i) generate an adjusted signal based on the first gain, the second gain, and at least one of the first amplified signal and the second amplified signal; and (ii) use the adjusted signal to generate an output of the sensor,
wherein, when the second amplified signal is less than a threshold, generating the adjusted signal includes scaling the first amplified signal based on a ratio of the first gain and the second gain, and setting the adjusted signal to equal the scaled first amplified signal, and, when the second amplified signal is greater than or equal to the threshold, generating the adjusted signal includes setting the adjusted signal to equal the second amplified signal.

**21.** The sensor of claim 20, or the method of claim 17, wherein the adjusted signal is generated in accordance with the equation of:

$$V_{ADJ} = \begin{cases} V_1 \dfrac{s_2}{s_1} & \text{for } V_2 < v_{max1} \\ V_2 & v_{max1} \leq V_2 \end{cases}$$

where $s_1$ is the first gain, $V_1$ is the first amplified signal, $s_2$ is the first gain $V_2$ is the first amplified signal, and $v_{max1}$ is the threshold.

**22.** The sensor of claim 20, wherein the one or more amplifiers include a first amplifier and a second amplifier, the first amplified signal is generated by using the first amplifier and the second amplified signal is generated by using the second amplifier.

**23.** The sensor of claim 20, wherein the one or more amplifiers include a programmable gain amplifier, the first amplified signal and the second amplified signal are both generated by using the programmable gain amplifier, and the first amplified signal and the second amplified signal are generated by alternating a gain setting of the programmable gain amplifier between at least the first gain and the second gain.

FIG. 1A

GAIN $S_1$ / GAIN $S_2$

100

102 SENSING ELEMENTS

S

PGA 124 $V_1 / V_2$

ADC 126

105

DIGITAL CIRCUITRY 128

PROCESSING CIRCUITRY 110 $V_{ADJ}$ $V_{OUT}$

MEMORY 111 (A)

**FIG. 1B**

**FIG. 1C**

EP 4 628 848 A1

200A

GENERATE A SENSING SIGNAL $\quad\overbrace{\phantom{xx}}^{202}$

GENERATE A SIGNAL $V_1$, THE SIGNAL $V_1$ BEING GENERATED AT LEAST IN PART BY AMPLIFYING THE SENSING SIGNAL WITH A FIRST GAIN $\quad\overbrace{\phantom{xx}}^{204}$

GENERATE A SIGNAL $V_2$, THE SIGNAL $V_2$ BEING GENERATED AT LEAST IN PART BY AMPLIFYING THE SENSING SIGNAL WITH A SECOND GAIN $\quad\overbrace{\phantom{xx}}^{206}$

RETRIEVE AN OFFSET PROPORTIONALITY CONSTANT $A$ $\quad\overbrace{\phantom{xx}}^{208}$

GENERATE AN ADJUSTED SIGNAL $V_{ADJ}$ BASED ON THE SIGNAL $V1$, THE SIGNAL $V_2$, THE VALUE OF THE FIRST GAIN, THE VALUE OF THE SECOND GAIN, AND THE OFFSET PROPORTIONALITY CONSTANT $A$ $\quad\overbrace{\phantom{xx}}^{210}$

# FIG. 2A

200B     212

| GENERATE A SENSING SIGNAL |
|---|

↓ 214

| GENERATE A SIGNAL $V_1$, THE SIGNAL $V_1$ BEING GENERATED AT LEAST IN PART BY AMPLIFYING THE SENSING SIGNAL WITH A FIRST GAIN |
|---|

↓ 216

| GENERATE A SIGNAL $V_2$, THE SIGNAL $V_2$ BEING GENERATED AT LEAST IN PART BY AMPLIFYING THE SENSING SIGNAL WITH A SECOND GAIN |
|---|

↓ 218

| RETRIEVE AN OFFSET PROPORTIONALITY CONSTANT $A$ |
|---|

↓ 220

| CALUCLATE AN OFFSET $V_{Q2}$ |
|---|

↓ 222

| GENERATE AN ADJUSTED $V_{ADJ}$ BY SUBTRACTING THE VALUE OF THE OFFSET $V_{Q2}$ FROM THE SIGNAL $V_2$ |
|---|

# FIG. 2B

<u>200C</u>                                                                    ┌─232

```
┌─────────────────────────────────────────────────────────┐
│              GENERATE A SENSING SIGNAL                    │
└─────────────────────────────────────────────────────────┘
```

┌─234

```
┌─────────────────────────────────────────────────────────┐
│      GENERATE A SIGNAL V₁, THE SIGNAL V₁ BEING           │
│   GENERATED AT LEAST IN PART BY AMPLIFYING THE           │
│        SENSING SIGNAL WITH A FIRST GAIN                   │
└─────────────────────────────────────────────────────────┘
```

┌─236

```
┌─────────────────────────────────────────────────────────┐
│      GENERATE A SIGNAL V₂, THE SIGNAL V₂ BEING           │
│   GENERATED AT LEAST IN PART BY AMPLIFYING THE           │
│        SENSING SIGNAL WITH A SECOND GAIN                  │
└─────────────────────────────────────────────────────────┘
```

┌─238

```
┌─────────────────────────────────────────────────────────┐
│   GENERATE AN ADJUSTED V_ADJ BY SUBTRACTING THE          │
│   VALUE OF THE OFFSET V_Q2 FROM THE SIGNAL V₂            │
└─────────────────────────────────────────────────────────┘
```

# FIG. 2C

FIG. 3

Europäisches
Patentamt

European
Patent Office

Office européen
des brevets

# EUROPEAN SEARCH REPORT

**Application Number**

EP 25 16 2462

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2015 101741 B4 (ANALOG DEVICES GLOBAL [BM]) 11 February 2021 (2021-02-11)<br><br>* Abstract, Desc. [0002], [0016]-[0029], Fig. 1 * | 1-11, 13-16, 20-23 | INV.<br>G01D3/036<br>G01R33/00 |
| X | US 2022/317160 A1 (MESSIER LOÏC ANDRÉ [FR]) 6 October 2022 (2022-10-06)<br>* Abstract, Desc. [0001], [0021]-[0026], Fig. 1a * | 1,5,12, 16,20 | |
| X | JP 2009 257811 A (DAIKIN IND LTD) 5 November 2009 (2009-11-05) | 17-19 | |
| A | * Abstract, Desc. [0001], [0008], [0017]-[0033], Figs. 2, 3 * | 1-16 | |
| X | JP 2013 113851 A (SAMSUNG ELECTRO MECH) 10 June 2013 (2013-06-10) | 17 | |
| A | * Abstract, Desc. [0047]-[0052], Figs. 2, 3 * | 1-16 | |

**TECHNICAL FIELDS SEARCHED (IPC)**

G01D

The present search report has been drawn up for all claims

| Place of search | Date of completion of the search | Examiner |
|---|---|---|
| Munich | 6 August 2025 | Reim, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 2462

This annex lists the patent family members relating to the patent documents cited in  the above-mentioned European search report.
The members are as contained in the European Patent Office EDP file on
The European Patent Office is in no way liable for these particulars which are merely given for the purpose of information.

06-08-2025

| Patent document cited in search report | Publication date | Patent family member(s) | Publication date |
|---|---|---|---|
| DE 102015101741 B4 | 11-02-2021 | NONE | |
| US 2022317160 A1 | 06-10-2022 | NONE | |
| JP 2009257811 A | 05-11-2009 | NONE | |
| JP 2013113851 A | 10-06-2013 | JP    2013113851 A<br>KR  20130060759 A<br>US    2013133397 A1 | 10-06-2013<br>10-06-2013<br>30-05-2013 |

EPO FORM P0459

For more details about this annex : see Official Journal of the European Patent Office, No. 12/82